# EUROPEAN PATENT APPLICATION

(11) **EP 4 521 896 A1**
(43) Date of publication of application: **12.03.2025**
(21) Application number: 24198343.6
(22) Date of filing: 04.09.2024
(51) Int. Cl.: H10K 59/121, H10K 59/80

(54) **DISPLAY PANEL**

(30) Priority: 06.09.2023 KR 20230118431
(71) Applicant: Samsung Display Co., Ltd., Gyeonggi-do 17113 (KR)
(72) Inventor: KIM, Sunkwang, 17113 Giheung-gu, Yongin-si, Gyeonggi-do (KR); LEE, Dong-Yoon, 17113 Giheung-Gu, Yongin-si, Gyeonggi-Do (KR); LEE, Seongyoung, 17113 Giheung-Gu, Yongin-si, Gyeonggi-Do (KR); LEE, Jeonghyun, 17113 Giheung-Gu, Yongin-si, Gyeonggi-Do (KR); LEE, Hanul, 17113 Giheung-Gu, Yongin-si, Gyeonggi-Do (KR); JO, Kangmoon, 17113 Giheung-Gu, Yongin-si, Gyeonggi-Do (KR)
(74) Representative: Dr. Weitzel & Partner

(57) **Abstract**

A display panel includes a base layer including a display area including a transmissive area and a non-display area adjacent to the display area, a first insulating layer; a transistor on the first insulating layer, a third insulating layer that covers the transistor, a first connection electrode connected to a semiconductor pattern through a contact hole defined in the third insulating layer, a fourth insulating layer that covers the first connection electrode, a pixel defining layer including a display opening not overlapping the transmissive area, and a light emitting element, wherein the fourth insulating layer includes a first insulating opening overlapping the transmissive area, and the pixel defining layer includes a transmissive opening overlapping the first insulating opening.

## Description

### BACKGROUND

### 1. Field

The present invention relates to a display panel, especially a transparent display panel.

### 2. Description of the Related Art

A display panel includes a plurality of pixels and a driving circuit (e.g., a scan driving circuit and a data driving circuit) that controls the plurality of pixels. Each of the plurality of pixels includes a display element and a pixel driving circuit that controls the display element. The pixel driving circuit may include a plurality of organically connected transistors.

In recent years, with the technological development, a transparent display panel has been developed in which a transmissive area within a display area is transparent. Accordingly, there is a need for design of the display panel for increasing transmittance of the transparent area within the display area.

The above information disclosed in this Background section is only for enhancement of understanding of the background and therefore the information discussed in this Background section does not necessarily constitute prior art.

### SUMMARY

Aspects of some embodiments of the present invention relate to a transparent display panel, and to a display panel including a circuit element having relatively improved transparency of a display area.

Aspects of some embodiments of the present invention include a transparent display panel for increasing transparency of a transmissive area within a display area.

The present invention is defined by the features of claim 1. The dependent claims describe preferred embodiments.

According to the invention, a display panel includes a base layer including a display area including a transmissive area and a non-display area being adjacent to the display area, a light shielding pattern on the base layer, a first insulating layer that covers the light shielding pattern, a transistor overlapping the light shielding pattern and including a semiconductor pattern on the first insulating layer and a gate on the semiconductor pattern, a second insulating layer between the semiconductor pattern and the gate, a third insulating layer that covers the transistor, a first connection electrode on the third insulating layer and connected to the semiconductor pattern through a contact hole defined in the third insulating layer, a fourth insulating layer that covers the first connection electrode, a pixel defining layer including a display opening not overlapping the transmissive area and on the fourth insulating layer, and a light emitting element on the fourth insulating layer and including a first electrode exposed by the display opening and connected to the first connection electrode and a second electrode, and a light emitting layer between the first electrode and the second electrode, wherein the fourth insulating layer includes a first insulating opening overlapping the transmissive area, and the pixel defining layer includes a transmissive opening overlapping the first insulating opening.

According to some embodiments, a width of the first insulating opening may be greater than a width of the transmissive opening on a plane.

According to some embodiments, a side surface of the fourth insulating layer, which defines the first insulating opening, may be in contract with the pixel defining layer.

According to some embodiments, the fourth insulating layer may include silicon nitride, and the pixel defining layer may include photosensitive polyimide (PSPI).

According to some embodiments, in the transmissive area, the third insulating layer may be exposed from the pixel defining layer through the transmissive opening.

According to some embodiments, the third insulating layer may include a second insulating opening overlapping the first insulating opening, and a side surface of the fourth insulating layer, which defines the first insulating opening, and a side surface of the third insulating layer, which defines the second insulating opening, may be in contact with the pixel defining layer.

According to some embodiments, in the transmissive area, the first insulating layer may be exposed from the pixel defining layer through the transmissive opening.

According to some embodiments, the first insulating layer may include a third insulating opening overlapping the second insulating opening, and a side surface of the first insulating layer, which defines the third insulating opening, may be in contact with the pixel defining layer.

According to some embodiments, in the transmissive area, the base layer may be exposed from the pixel defining layer through the transmissive opening.

According to some embodiments, the display panel may further include a data line connected to the transistor, wherein the data line may be on the same layer as that of the light shielding pattern.

According to some embodiments, an area of the display opening may be smaller than an area of the transmissive opening.

According to some embodiments, the display panel may further include a fifth insulating layer between the fourth insulating layer and the pixel defining layer, wherein the fifth insulating layer may include an upper insulating opening overlapping the first insulating opening, and a side surface of the fifth insulating layer, which defines the upper insulating opening, may be in contact with the pixel defining layer.

According to some embodiments, an upper surface of the fourth insulating layer, which is adjacent to a side surface of the fourth insulating layer, which defines the first insulating opening, may be exposed from the fifth insulating layer through the upper insulating opening, and the upper surface may be in contact with the pixel defining layer.

According to some embodiments, the fifth insulating layer may include photosensitive polyimide (PSPI).

According to some embodiments, the display panel may further include a second connection electrode on the fourth insulating layer, covered by the fifth insulating layer, and connected to the first connection electrode through a contact hole defined in the fourth insulating layer.

According to some embodiments, the first insulating layer may include a first layer including silicon nitride and a second layer including silicon oxide, the second insulating layer may include silicon oxide, and the third insulating layer may include silicon oxy nitride.

According to some embodiments, each of the light shielding pattern and the gate may include a first layer including titanium and a second layer including copper, the semiconductor pattern may include indium gallium zinc oxide (IGZO), and the first connection electrode may include a first layer including titanium, a second layer including copper, and a third layer including indium tin oxide (ITO).

According to some embodiments, the first electrode may include a first layer including indium tin oxide (ITO), a second layer including silver, and a third layer including ITO.

According to some embodiments, the display panel may further include an encapsulation layer that covers the light emitting element and includes inorganic layers and an organic layer between the inorganic layers.

According to some embodiments, a virtual object on a rear surface of the display panel may be transparent and visible from a front surface of the display panel.

### BRIEF DESCRIPTION OF THE DRAWINGS

The above and other aspects and features of embodiments according to the present invention will become more apparent by describing in more detail aspects of some embodiments thereof with reference to the accompanying drawings.
FIG. 1A is a perspective view of a display panel according to some embodiments of the present invention.
FIG. 1B is a perspective view of a curved display panel according to some embodiments of the present invention.
FIG. 2 is a cross-sectional view of the display panel according to some embodiments of the present invention.
FIG. 3A is a plan view of a display panel according to some embodiments of the present invention.
FIG. 3B is an enlarged plan view of a display area of the display panel according to some embodiments of the present invention.
FIG. 4 is an equivalent circuit diagram of a pixel according to some embodiments of the present invention.
FIG. 5 is a cross-sectional view along the line I-I' of FIG. 3B
FIG. 6A is a cross-sectional view taken along the line II-II' of FIG. 3B.
FIG. 6B is a cross-sectional view of the display panel according to some embodiments of the present invention.
FIG. 6C is a cross-sectional view of the display panel according to some embodiments of the present invention.
FIGS. 7A to 7H are plan views illustrating a laminated sequence of conductive patterns arranged in area QQ' of FIG. 3B, which is distinguished according to each layer.
FIGS. 8A to 8C are cross-sectional views according to comparative examples.

### DETAILED DESCRIPTION

In the present specification, the expression that a first component (or area, layer, part, portion, etc.) is "on", "connected with", or "coupled to" a second component means that the first component is directly on, connected with, or coupled to the second component or means that a third component is interposed therebetween.

The same reference numerals refer to the same components. Further, in the drawings, the thickness, the ratio, and the dimension of components are exaggerated for effective description of technical contents. The expression "and/or" includes one or more combinations which associated components are capable of defining.

Although the terms "first", "second", etc. may be used to describe various components, the components should not be limited by the terms. The terms are only used to distinguish one component from another component. For example, without departing from the scope of the present invention, a first component may be referred to as a second component, and similarly, the second component may be also referred to as the first component. Singular expressions include plural expressions unless clearly otherwise indicated in the context.

Also, the terms "under", "below", "on", "above", etc. are used to describe the correlation of components illustrated in drawings. The terms that are relative in concept are described based on a direction illustrated in drawings.

It will be understood that the terms "include", "comprise", "have", etc. specify the presence of features, numbers, steps, operations, elements, or components, described in the specification, or a combination thereof, and do not exclude in advance the presence or additional possibility of one or more other features, numbers, steps, operations, elements, or components or a combination thereof.

Unless otherwise defined, all terms (including technical terms and scientific terms) used in the present specification have the same meaning as commonly understood by those skilled in the art to which the present invention belongs. Furthermore, terms such as terms defined in the dictionaries commonly used should be interpreted as having a meaning consistent with the meaning in the context of the related technology, and should not be interpreted in overly ideal or overly formal meanings unless explicitly defined herein.

Hereinafter, aspects of some embodiments of the present invention will be described in more detail with reference to accompanying drawings.

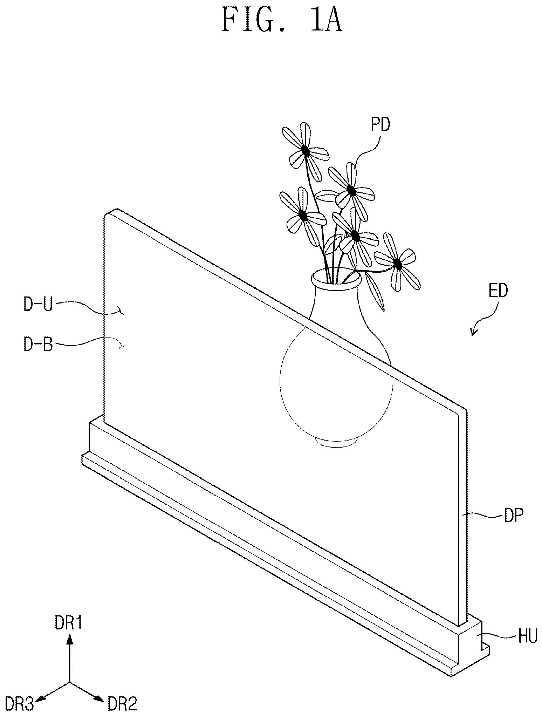

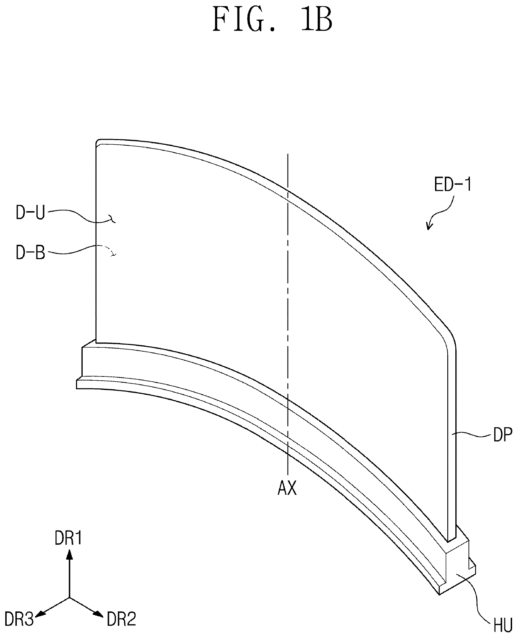

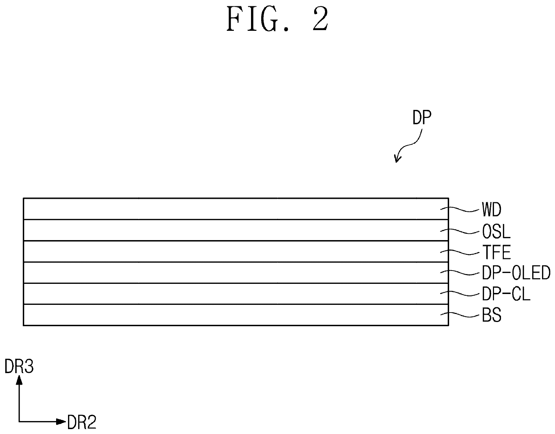

FIG. 1A is a perspective view of a display panel according to some embodiments of the present invention. FIG. 1B is a perspective view of a curved display panel according to some embodiments of the present invention. FIG. 2 is a cross-sectional view of the display panel according to some embodiments of the present invention.

Electronic devices ED and ED-1 illustrated in FIGS. 1A and 1B may each include a display panel DP and a housing HU that accommodates at least a portion of the display panel DP. For example, a portion of a lower end of the display panel DP may be accommodated in the housing HU.

The display panel DP, which is a light emitting display panel, may be one of a liquid crystal display panel, an electrophoretic display panel, a microelectromechanical system (MEMS) display panel, an electrowetting display panel, an organic light emitting display panel, an inorganic light emitting display panel, and a quantum-dot display panel, and embodiments according to the present invention are not particularly limited thereto.

Referring to FIG. 1A, the display panel DP may display images through a front surface D-U. An upper surface of a member located on an uppermost side of the display panel DP may be defined as the front surface D-U of the display panel DP. According to the present invention, an upper surface of a window panel WD illustrated in FIG. 2 may be defined as the front surface D-U of the display panel DP.

According to some embodiments, the front surface D-U is parallel to a plane defined by a first direction DR1 and a second direction DR2. A normal direction of the front surface D-U, that is, a thickness direction of the display panel DP, indicates a third direction DR3. Hereinafter, front surfaces (or upper surfaces) and rear surfaces (or lower surfaces) of layers or units, which will be described in more detail below, are distinguished by the third direction DR3.

The display panel DP according to some embodiments may be a transparent display panel DP. The transparent display panel DP may display information in a state in which an object PD located on a rear side of the display panel DP (e.g., an object PD facing a rear surface D-B of the display panel DP) is transparently transmitted on the front surface D-U of the display panel DP. Thus, a user may recognize the object PD located on the rear side of the display panel DP through the front surface D-U of the display panel DP. The information is an image, a content, a playback screen, an application execution screen, a web browser screen, and various graphic objects, but is not limited to any one thereof. FIG. 1A illustrates a vase as an example of the object PD, but embodiments according to the present invention are not limited thereto, and the object PD is not limited to any one as long as the object PD has a specific shape.

The housing HU may protect the display panel DP from an external impact or intrusion of foreign substances. The housing HU may be made of a material such as a plastic or a metal. However, this is only an example, and the material is not limited thereto as long as the material may protect the display panel DP from an external impact or intrusion of foreign substances. In the electronic device ED according to some embodiments, the housing HU is omitted, but in the electronic device ED according to some other embodiments, the display panel DP may be rolled through a separate hinge member and located inside the housing HU, and embodiments according to the present invention are not limited thereto.

Referring to FIG. 1B, the electronic device ED-1 according to some embodiments may be curved in the second direction DR2 with respect to a virtual axis AX extending in the first direction DR1. Thus, the display panel DP may be curved with a curvature (e.g., a set or predetermined curvature), and the housing HU may have a curvature corresponding thereto. Embodiments according to the present invention are not limited thereto, and the virtual axis AX may extend in the second direction DR2 or the display panel DP may be curved with respect to a plurality of axes extending in different directions.

Further, the display panel DP may be a rollable display panel, a foldable display panel, or a slidable display panel, and in an operating state, the entire display panel DP may be located inside the housing HU. Accordingly, the display panel DP may include a curved display surface or a three-dimensional display surface. The three-dimensional display surface may include a plurality of display areas indicating different directions.

Referring to FIG. 2, the display panel DP according to some embodiments of the present invention includes a base layer BS, a circuit element layer DP-CL located on the base layer BS, a display element layer DP-OLED, an encapsulation layer TFE, a light control layer OSL, and the window panel WD. The display panel DP may further include functional layers such as a reflection preventing layer or a refractive index adjusting layer. The circuit element layer DP-CL includes at least a plurality of insulating layers and a circuit element. The insulating layers, which will be described below, may include organic layers and/or inorganic layers.

The base layer BS may include a synthetic resin layer. The synthetic resin layer may include a thermosetting resin. In particular, the synthetic resin layer may be a polyimide-based resin layer, and a material thereof is not particularly limited thereto. The synthetic resin layer may include at least one of an acrylic resin, a methacrylic resin, a polyisoprene resin, a vinyl resin, an epoxy resin, a urethane resin, a cellulose resin, a siloxane resin, a polyamide resin, and a perylene resin. In addition, the base layer BS may include a glass substrate, a metal substrate, an organic/inorganic composite material substrate, or the like.

The circuit element layer DP-CL forms an insulating layer, a semiconductor layer, and a conductive layer through processes such as coating and deposition. Thereafter, the insulating layer, the semiconductor layer, and the conductive layer may be selectively patterned through photolithography and etching processes. A semiconductor pattern, a conductive pattern, a signal line or the like are formed through these processes. The patterns arranged on the same layer are formed through the same process.

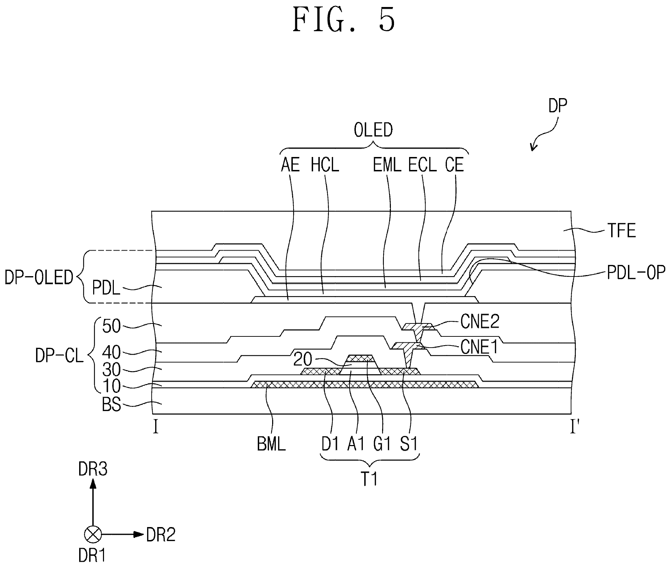

The circuit element layer DP-CL includes a driving circuit or signal lines that drives a pixel PX. The display element layer DP-OLED may include a light emitting element OLED (see FIG. 5) and a pixel defining layer PDL (see FIG. 5) included in the pixel PX.

The encapsulation layer TFE may be located on the display element layer DP-OLED to protect the light emitting element OLED. The encapsulation layer TFE may include inorganic layers and an organic layer located between the inorganic layers. The inorganic layers may protect the light emitting element OLED from moisture and oxygen, and the organic layer may protect the light emitting element OLED from foreign substances such as dust particles.

The light control layer OSL may include color control layers that may change optical properties of a source light beam generated by the light emitting element OLED. The color control layers may include quantum dots, and the light control layer OSL may include color filters that selectively transmit light beams passing through the color control layers. According to some embodiments, the light control layer OSL may be omitted.

The window panel WD may be located on the display panel DP and transmit an image provided from the display panel DP to the outside. The window panel WD may include a base layer and functional layers arranged on the base layer. The functional layers may include a protective layer, a fingerprint preventing layer, and the like. The base layer of the window panel WD may be made of glass, sapphire, or plastic.

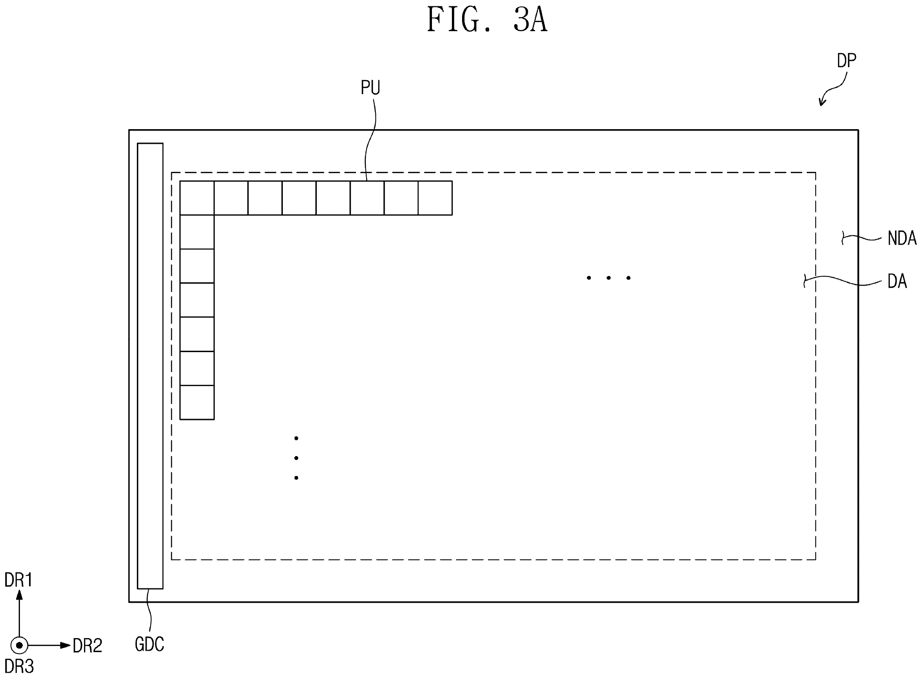

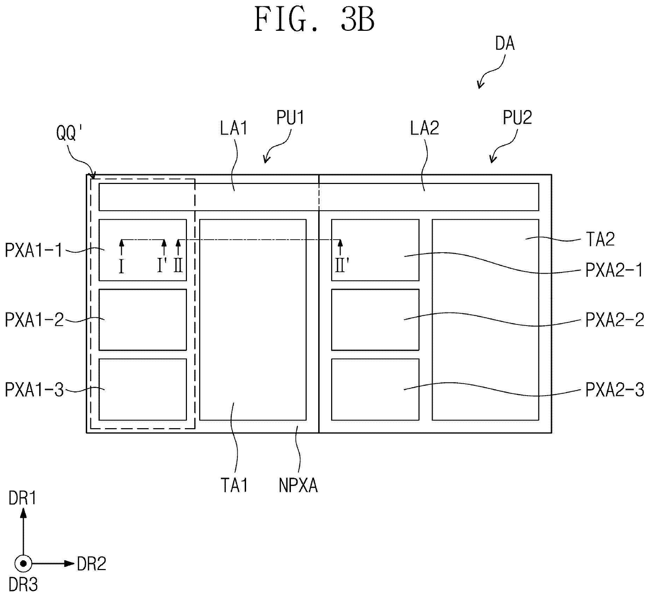

FIG. 3A is a plan view of a display area according to some embodiments of the present invention. FIG. 3B is an enlarged plan view of a display area of the display panel according to some embodiments of the present invention.

Referring to FIGS. 3A and 3B, the display panel DP according to some embodiments may include pixels arranged in a unit area PU, a gate driving circuit GDC connected to the pixels, and signal lines.

The display panel DP may include a display area DA and a non-display area NDA. A light emitting layer EML (see FIG. 5) of the pixel located in the unit area PU is located in the display area DA, and the light emitting layer EML is not located in the non-display area NDA. The non-display area NDA may surround the display area DA. According to some embodiments of the present invention, the non-display area NDA may be omitted or located on only one side of the display area DA.

A plurality of unit areas PU may be provided within the display area DA. The unit areas PU may be arranged in the first direction DR1 and the second direction DR2. The unit areas PU may include light emitting areas by which the display panel DP provides information to the user, a transmissive area that increases transparency of the display panel DP so that the object PD located on the rear side of the display panel DP may be transmitted to the user, and a wiring area in which the signal lines connected to the pixels are arranged.

FIG. 3B illustrates aspects of two first and second unit areas PU1 and PU2 arranged in the second direction DR2 among the unit areas PU, according to some embodiments.

The first unit area PU1 may include light emitting areas PXA1-1, PXA1-2, and PXA1-3 spaced apart from each other in the first direction DR1, a first transmissive area TA1 spaced apart from the light emitting areas PXA1-1, PXA1-2, and PXA1-3 in the second direction DR2, and a first wiring area LA1 spaced apart from the (1-1)^{th} light emitting area PXA1-1 and the first transmissive area TA1 in the first direction DR1 and extending in the second direction DR2.

The second unit area PU2 may include light emitting areas PXA2-1, PXA2-2, and PXA2-3 spaced apart from each other in the first direction DR1, a second transmissive area TA2 spaced apart from the light emitting areas PXA2-1, PXA2-2, and PXA2-3 in the second direction DR2, and a second wiring area LA2 spaced apart from the (2-1)^{th} light emitting area PXA2-1 and the second transmissive area TA2 in the first direction DR1 and extending in the second direction DR2. A non-light emitting area NPXA may surround the light emitting areas and the wiring areas.

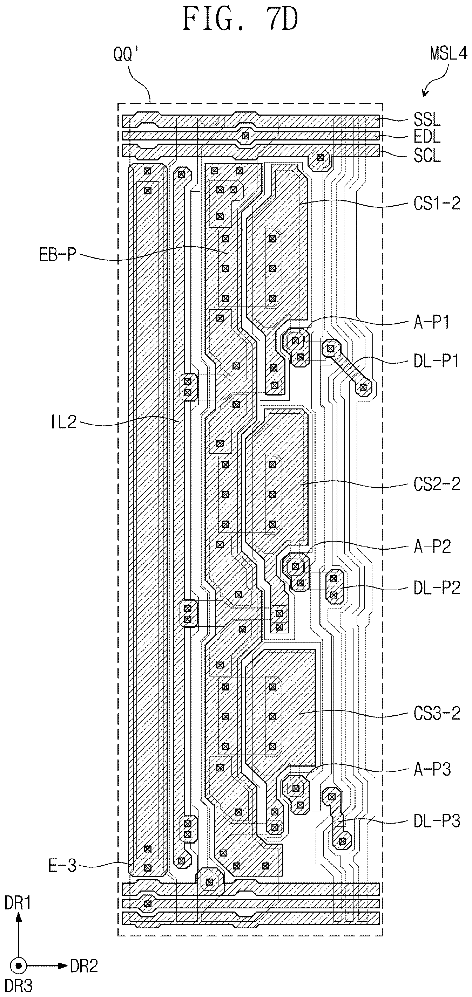

According to some embodiments, the first wiring area LA1 and the second wiring area LA2 may be connected to each other and extend in the second direction DR2. The signal lines commonly connected to the pixels arranged in the light emitting areas may be arranged in the first wiring area LA1 and the second wiring area LA2. For example, a sensing line SSL, a power line EDL, and a scan line SCL, which will be described with reference to FIG. 7D, may be arranged in the wiring areas LA1 and LA2.

According to the present invention, wavelengths of source light beams provided by the light emitting areas PXA1-1, PXA1-2, PXA1-3, PXA2-1, PXA2-2, and PXA2-3 may be different from each other. The light emitting areas PXA1-1, PXA1-2, PXA1-3, PXA2-1, PXA2-2, and PXA2-3 may be defined by display opening PDL-OP included in the pixel defining layer PDL (see FIG. 5), and the transmissive areas TA1 and TA2 may be defined by a transmissive opening T-OP included in the pixel defining layer PDL (see FIG. 5). An area of the display opening PDL-OP may be smaller than an area of the transmissive opening T-OP. A description related thereto will be made below.

Referring back to FIG. 3A, the gate driving circuit GDC may be located in the non-display area NDA. The gate driving circuit GDC may be integrated into the display panel DP through an oxide silicon gate (OSG) driver circuit process or an amorphous silicon gate (ASG) driver circuit process.

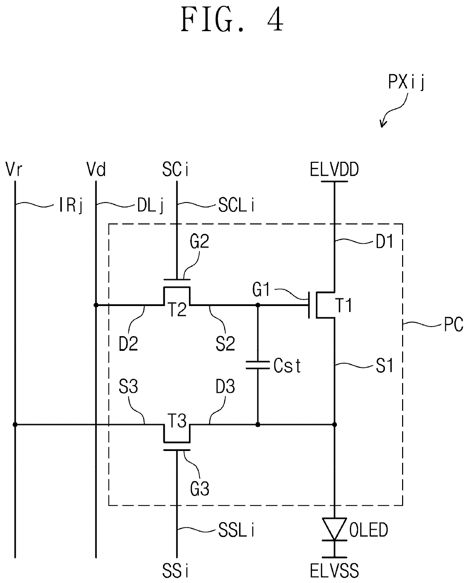

FIG. 4 is an equivalent circuit diagram of a pixel according to some embodiments of the present invention.

FIG. 4 illustrates aspects of a circuit diagram related to one pixel PXij in the unit area PU (see FIG. 3A), according to some embodiments.

Referring to FIG. 4, the pixel PXij may include a pixel circuit PC and the light emitting element OLED. The pixel circuit PC may include a plurality of transistors T1 to T3 and a capacitor Cst.

The plurality of transistors T1 to T3 may be formed through a low temperature polycrystalline silicon (LTPS) process or a low temperature polycrystalline oxide (LTPO) process. Each of the first to third transistors T1 to T3 may include either a silicon semiconductor or an oxide semiconductor. In this case, the oxide semiconductor may include a crystalline or amorphous oxide semiconductor, the silicon semiconductor may include amorphous silicon, polycrystalline silicon or the like, and embodiments according to the present invention are not limited thereto.

Hereinafter, it will be described that the first to third transistors T1 to T3 are of N type, but embodiments according to the present invention are not limited thereto, and each of the first to third transistors T1 to T3 may be a P-type transistor or an N-type transistor according to a signal applied thereto. In this case, a source and a drain of the P-type transistor may correspond to a drain and a source of the N-type transistor, respectively.

FIG. 4 illustrates aspects of the pixel PXij connected to an i^{th} scan line SCLi, an i^{th} sensing line SSLi, a j^{th} data line DLj and a j^{th} reference line IRj according to some embodiments.

The pixel PXij illustrated in FIG. 4 may correspond to one of the pixels included in the unit area PU (see FIG. 3A). The pixel circuit PC may include the first transistor T1 (a driving transistor), the second transistor T2 (a switch transistor), the third transistor T3 (a sensing transistor), and the capacitor Cst. However, the pixel circuit PC may further include an additional transistor and an additional capacitor, and embodiments according to the present invention are not limited thereto. That is, according to various embodiments, the pixel circuit PC may include additional components or fewer components without departing from the scope of embodiments according to the present invention.

The first to third transistors T1 to T3 may include sources S1, S2, and S3, drains D1, D2, and D3, and gates G1, G2, and G3, respectively.

The light emitting element OLED may be an organic light emitting element or inorganic light emitting element including an anode (a first electrode) and a cathode (a second electrode). The anode of the light emitting element OLED may receive a first voltage ELVDD through the first transistor T1, and the cathode of the light emitting element OLED may receive a second voltage ELVSS. The light emitting element OLED may emit a light beam by receiving the first voltage ELVDD and the second voltage ELVSS.

The first transistor T1 may include the drain D1 that receives the first voltage ELVDD, the source S1 connected to the anode of the light emitting element OLED, and the gate G1 connected to the capacitor Cst. The first transistor T1 may control a driving current flowing through the light emitting element OLED from the first voltage ELVDD in response to a voltage value stored in the capacitor Cst.

The second transistor T2 may include the drain D2 connected to the j^{th} data line DLj, the source S2 connected to the capacitor Cst, and the gate G2 that receives an i^{th} writing scan signal SCi. The second transistor T2 provides a data voltage Vd to the first transistor T1 in response to the i^{th} writing scan signal SCi.

The third transistor T3 may include the source S3 connected to the j^{th} reference line IRj, the drain D3 connected to the anode of the light emitting element OLED, and the gate G3 that receives an i^{th} sampling scan signal SSi. The j^{th} reference line IRj may receive a reference voltage Vr.

The capacitor Cst may store various voltage difference values according to an input signal. For example, the capacitor Cst may store a voltage corresponding to a difference between a voltage received from the second transistor T2 and the first voltage ELVDD.

In the present invention, an equivalent circuit of the pixel PXij is not limited to an equivalent circuit illustrated in FIG. 4. According to some embodiments of the present invention, the pixel PXij may be implemented in various forms to allow the light emitting element OLED to emit a light beam.

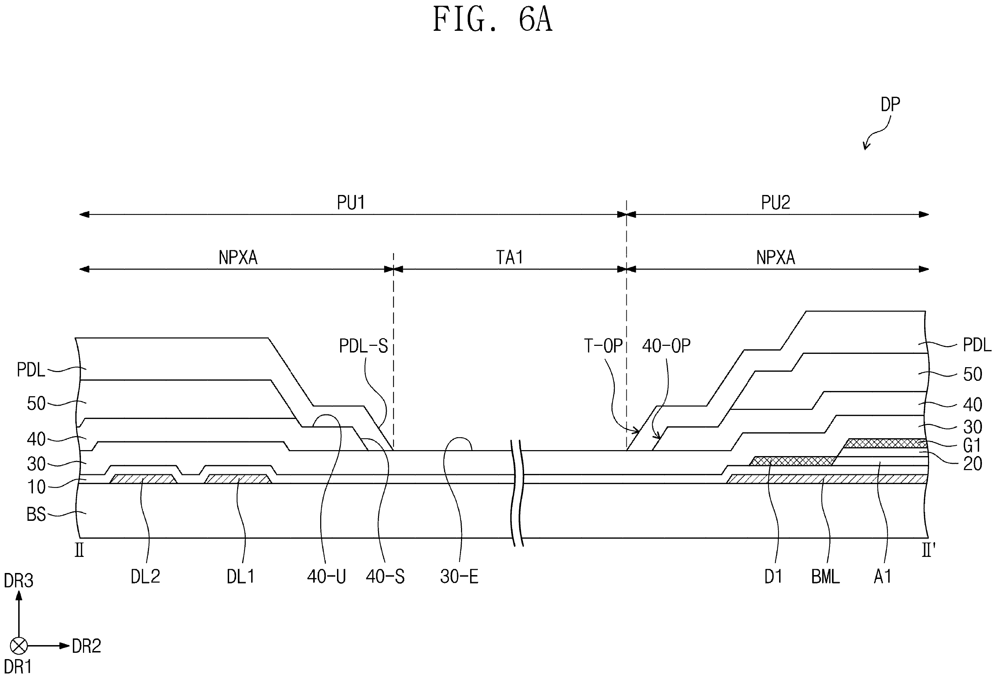

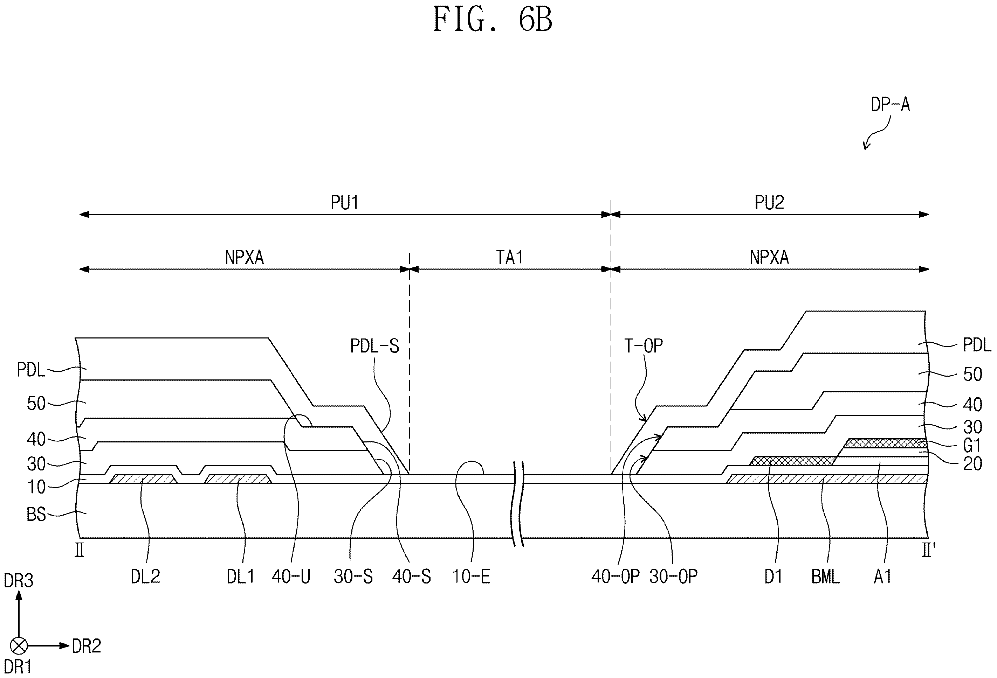

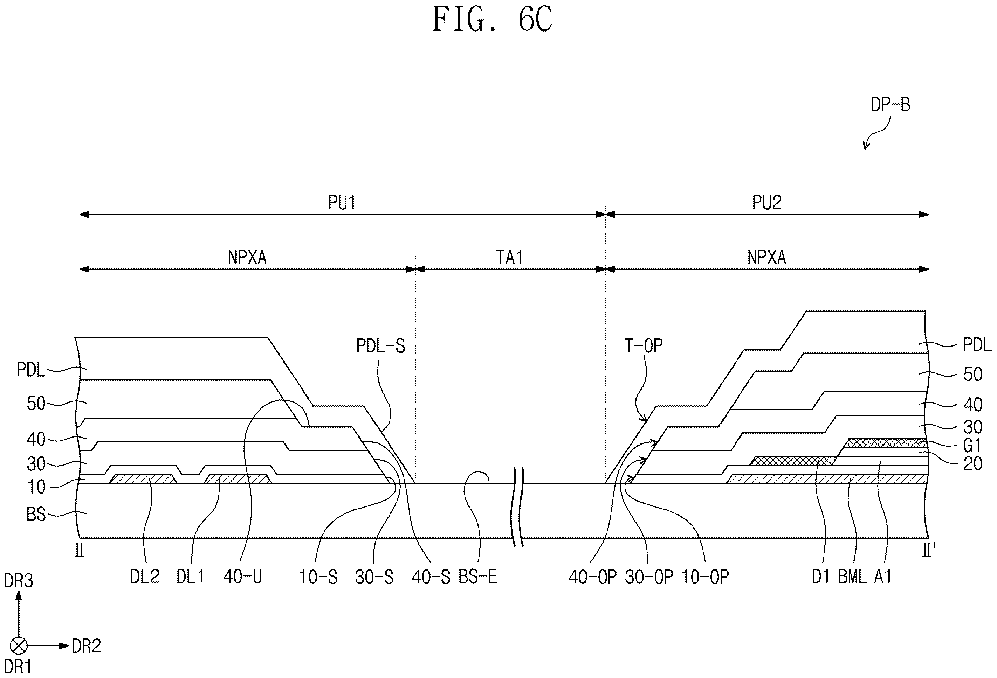

FIG. 5 is a cross-sectional view along the line I-I' of FIG. 3B. FIG. 6A is a cross-sectional view taken along the line II-II' of FIG. 3B. FIG. 6B is a cross-sectional view of the display panel according to some embodiments of the present invention. FIG. 6C is a cross-sectional view of the display panel according to some embodiments of the present invention. FIG. 5 illustrates only some of the components of the display panel DP, and the light control layer OSL and the window panel WD are omitted.

Referring to FIG. 5, the display panel DP may include the base layer BS, the circuit element layer DP-CL located on the base layer BS, the display element layer DP-OLED, and the encapsulation layer TFE.

The base layer BS may include a synthetic resin layer. The synthetic resin layer may include a thermosetting resin. In particular, the synthetic resin layer may include at least one of an acrylic resin, a methacrylic resin, a polyisoprene resin, a vinyl resin, an epoxy resin, a urethane resin, a cellulose resin, a siloxane resin, a polyamide resin, and a perylene resin. In addition, the base layer BS may include a glass substrate, a metal substrate, an organic/inorganic composite material substrate, or the like.

The circuit element layer DP-CL forms the insulating layer, the semiconductor layer, and the conductive layer through processes such as coating and deposition. Thereafter, the insulating layer, the semiconductor layer, and the conductive layer may be selectively patterned through photolithography and etching processes. The semiconductor pattern, the conductive pattern, the signal line or the like are formed through these processes. The patterns arranged on the same layer are formed through the same process.

The circuit element layer DP-CL includes the driving circuit or signal line constituting the pixel PX. The display element layer DP-OLED may include the light emitting element OLED (see FIG. 4) and the pixel defining layer PDL included in the pixel PX.

The circuit element layer DP-CL may include first to fifth insulating layers 10, 20, 30, 40, and 50 and conductive patterns. According to some embodiments, the first insulating layer 10 to the fourth insulating layer 40 may be inorganic layers including a single layer or multiple layers, and the fifth insulating layer 50 may be an organic layer.

A light shielding pattern BML may be located on the base layer BS. According to some embodiments, the light shielding pattern BML may be connected to the semiconductor pattern of the overlapping transistor T1, may receive a signal applied to the semiconductor pattern, and may form a sync structure under the semiconductor pattern. According to some embodiments, the light shielding pattern BML may include sequentially laminated metal layers. A first layer may include titanium, and a second layer may include copper.

The first insulating layer 10 may be located on the base layer BS and cover the light shielding pattern BML. According to some embodiments, the first insulating layer 10 may include sequentially laminated inorganic layers. A first layer may include silicon nitride, and a second layer may include silicon oxide.

The semiconductor pattern of the transistor T1 may be located on the first insulating layer 10. The semiconductor pattern may include a source S1, a channel area A1 (or an active area), and a drain D1. According to some embodiments, the semiconductor pattern may include indium gallium zinc oxide (IGZO).

The second insulating layer 20 may be located between the semiconductor pattern and the gate G1. The second insulating layer 20 may expose an area of the semiconductor pattern other than the active pattern A1. The second insulating layer 20 may be patterned using the gate G1 as a mask. According to some embodiments, the second insulating layer 20 may include silicon oxide.

The gate G1 may be located on the second insulating layer 20. According to some embodiments, the gate G1 may include sequentially laminated metal layers. A first layer may include titanium, and a second layer may include copper.

The third insulating layer 30 may be located on the first insulating layer 10 and the second insulating layer 20 and cover the gate G1 and the semiconductor pattern exposed from the gate G1. According to some embodiments, the third insulating layer 30 may include silicon oxy nitride.

A first connection electrode CNE1 may be located on the third insulating layer 30. The first connection electrode CNE1 may be connected to the source S1 through a contact hole defined in the third insulating layer 30. According to some embodiments, the first connection electrode CNE1 may include sequentially laminated metal layers and metal oxide layers. For example. a first layer of the first connection electrode CNE1 may include titanium, a second layer may include copper, and a third layer may include indium tin oxide (ITO).

The fourth insulating layer 40 may be located on the third insulating layer 30 and cover the first connection electrode CNE1. According to some embodiments, the fourth insulating layer 40 may include silicon oxy nitride. A layer including the silicon nitride has a dense film quality as compared to a layer including silicon oxide and/or silicon oxy nitride, thereby reducing transmittance. Thus, to increase transmittance in the transparent display panel DP as in the present invention, removal of silicon nitride from the transmissive areas TA1 and TA2 are required.

A second connection electrode CNE2 may be located on the fourth insulating layer 40. The second connection electrode CNE2 may be connected to the first connection electrode CNE1 through a contact hole defined in the fourth insulating layer 40. According to some embodiments, the second connection electrode CNE2 may include the same material as that of the first connection electrode CNE1. In the display panel DP according to some embodiments, the second connection electrode CNE2 may be omitted, and embodiments according to the present invention are not limited thereto.

The fifth insulating layer 50 may be located on the fourth insulating layer 40 and cover the second connection electrode CNE2. According to some embodiments, the fifth insulating layer 50 may include an organic material. For example, the fifth insulating layer 50 may include photosensitive polyimide (PSPI).

The display element layer DP-OLED may be located on the fifth insulating layer 50. The display element layer DP-OLED may include the light emitting element OLED and the pixel defining layer PDL. The light emitting element OLED may include a first electrode AE, the light emitting layer EML, and a second electrode CE. The light emitting element OLED according to some embodiments may further include a hole control layer HCL and an electron control layer ECL.

The pixel defining layer PDL may be located on the fifth insulating layer 50 and cover the second connection electrode CNE2. The pixel defining layer PDL may include an organic material. For example, the pixel defining layer PDL may include PSPI. The pixel defining layer PDL may include the display opening PDL-OP. A plurality of display openings PDL-OP of the pixel defining layer PDL may be provided, and the display openings PDL-OP may be defined by the light emitting areas described in FIG. 3B. An area in which the pixel defining layer PDL is located may be defined as a non-light emitting area.

The first electrode AE of the light emitting element OLED is located on the fifth insulating layer 50. The display opening PDL-OP of the pixel defining layer PDL exposes at least a portion of the first electrode AE. According to some embodiments, the first electrode AE may include sequentially laminated metal layers. A first layer may include indium tin oxide (ITO), a second layer may include silver, and a third layer may include indium tin oxide (ITO).

The hole control layer HCL may be commonly located in the light emitting area and the non-light emitting area. A common layer such as the hole control layer HCL may be commonly arranged in the pixels. In the present specification, layers formed as common layers may be entirely arranged in the display area DA (see FIG. 3A) and the non-display area NDA (see FIG. 3A). The hole control layer HCL may include a hole transport layer and a hole injection layer.

The light emitting layer EML is located on the hole control layer HCL. The light emitting layer EML may be commonly arranged in the light emitting area and the non-light emitting area. The light emitting layer EML may generate a source light beam. The light emitting layer EML may include an organic light emitting material or an inorganic light emitting material. According to some embodiments, source light beams generated by the pixels arranged in the one unit area PU may have different colors.

An electron control layer ECL is located on the light emitting layer EML. The electron control layer ECL may include an electron transport layer and an electron injection layer. The second electrode CE is located on the electron control layer ECL. According to some embodiments, the second electrode CE may be described as a cathode. The hole control layer HCL, the light emitting layer EML, and the electron control layer ECL may be defined as common layers.

The encapsulation layer TFE may be located on the display element layer DP-OLED to protect the light emitting element OLED. The encapsulation layer TFE may include inorganic layers and an organic layer located between the inorganic layers. The inorganic layers may protect the light emitting element OLED from moisture and oxygen, and the organic layer may protect the light emitting element OLED from foreign substances such as dust particles.

The inorganic layers may prevent external moisture or oxygen from penetrating into the light emitting layer EML. The inorganic layers may include silicon nitride, silicon oxide, or compounds obtained by combining them. The inorganic layers may be formed through a deposition process.

The organic layer may provide a planarization surface on the inorganic layer. Curves formed in an upper surface of the inorganic layer or particles present on the inorganic layer may be covered by the organic layer, and thus a surface condition of the upper surface of the inorganic layer may be prevented from affecting components formed on the organic layer. The organic layer may include an organic material.

Referring to FIG. 6A, in the display panel DP according to some embodiments, at least some of the insulating layers arranged in the transmissive area TA1 may be removed to relatively improve transmittance of the transmissive area TA1.

According to some embodiments, the base layer BS, the first insulating layer 10, and the third insulating layer 30 may be arranged in the transmissive area TA1. The fourth insulating layer 40 may include a first insulating opening 40-OP that overlaps the transmissive area TA1. The first insulating opening 40-OP may be defined by a side surface 40-S of the fourth insulating layer 40, which is formed as a portion of the fourth insulating layer 40, which overlaps the transmissive area TA1, is passed therethrough. The first insulating opening 40-OP may be formed by removing the fourth insulating layer 40 through a dry etching process. The fifth insulating layer 50 may include an upper insulating opening overlapping the first insulating opening 40-OP.

In the pixel defining layer PDL, the display opening PDL-OP (see FIG. 5) corresponding to the light emitting areas PXA1-1, PXA1-2, and PXA1-3 described in FIG. 3B and a transmissive opening T-OP corresponding to the transmissive area TA1 described in FIG. 3B may be defined. The transmissive opening T-OP may overlap the first insulating opening 40-OP. The transmissive opening T-OP may be defined by a side surface PDL-S of the pixel defining layer PDL, which is formed as a portion of the pixel defining layer PDL, which overlaps the transmissive area TA1, is passed therethrough.

According to some embodiments, in the second direction DR2, a width of the first insulating opening 40-OP may be greater than a width of the transmissive opening T-OP.

According to some embodiments, the side surface 40-S of the fourth insulating layer 40 that defines the first insulating opening 40-OP may be covered by the pixel defining layer PDL. That is, the side surface 40-S of the fourth insulating layer 40 may be in contact with the pixel defining layer PDL. Further, an upper surface 40-U of the fourth insulating layer 40, which is exposed from the fifth insulating layer 50, may be also in contact with the pixel defining layer PDL. According to some embodiments, the fourth insulating layer 40 may be spaced apart from the transmissive area TA1.

According to some embodiments, an upper surface 30-E of the third insulating layer 30 may be exposed from the fourth insulating layer 40 and the pixel defining layer PDL through the first insulating opening 40-OP and the transmissive opening T-OP. Common layers included in the encapsulation layer TFE and/or the light emitting element OLED may be arranged on the upper surface 30-E of the third insulating layer 30.

The above description of the transmissive area TA1 may be commonly applied to the unit areas PU described in FIG. 3A. Thus, on a plane, a plurality of openings spaced apart from each other in the first direction DR1 and the second direction DR2 may be defined in the fourth insulating layer 40 and the pixel defining layer PDL. The openings may be arranged in the first direction DR1 and the second direction DR2 on a plane.

According to the present invention, the fourth insulating layer 40 including silicon nitride may not be located in the transmissive area TA1 of the transparent display panel DP. Thus, the transmittance of the transmissive area TA1 may be relatively improved. Further, as the side surface 40-S of the fourth insulating layer 40 that defines the first insulating opening 40-OP is covered by the pixel defining layer PDL, a phenomenon in which the fourth insulating layer 40 is peeled off from the third insulating layer 30 in an area adjacent to the transmissive area TA1 may be reduced. Accordingly, the display panel DP having relatively improved transmittance and relatively improved reliability may be provided.

Referring to FIG. 6B, in a display panel DP-A according to some embodiments, at least some of the insulating layers arranged in the transmissive area TA1 may be removed to relatively improve the transmittance of the transmissive area TA1.

According to some embodiments, the base layer BS and the first insulating layer 10 may be arranged in the transmissive area TA1. The fourth insulating layer 40 may include the first insulating opening 40-OP that overlaps the transmissive area TA1. The first insulating opening 40-OP may be defined by the side surface 40-S of the fourth insulating layer 40, which is formed as the portion of the fourth insulating layer 40, which overlaps the transmissive area TA1, is passed therethrough.

According to some embodiments, the third insulating layer 30 may include a second insulating opening 30-OP that overlaps the transmissive area TA1. The second insulating opening 30-OP may overlap the first insulating opening 40-OP. The second insulating opening 30-OP may be defined by a side surface 30-S of the third insulating layer 30, which is formed as a portion of the third insulating layer 30, which overlaps the transmissive area TA1, is passed therethrough.

In the pixel defining layer PDL, the display opening PDL-OP (see FIG. 5) corresponding to the light emitting areas PXA1-1, PXA1-2, and PXA1-3 described in FIG. 3B and the transmissive opening T-OP corresponding to the transmissive area TA1 described in FIG. 3B may be defined. The transmissive opening T-OP may overlap the first insulating opening 40-OP and the second insulating opening 30-OP. The transmissive opening T-OP may be defined by the side surface PDL-S of the pixel defining layer PDL, which is formed as the portion of the pixel defining layer PDL, which overlaps the transmissive area TA1, is passed therethrough.

According to some embodiments, in the second direction DR2, the width of the first insulating opening 40-OP may be greater than the width of the transmissive opening T-OP and a width of the second insulating opening 30-OP.

According to some embodiments, the side surface 40-S of the fourth insulating layer 40 that defines the first insulating opening 40-OP and the side surface 30-S of the third insulating layer 30 that defines the second insulating opening 30-OP may be covered by the pixel defining layer PDL. That is, the side surface 40-S of the fourth insulating layer 40 and the side surface 30-S of the third insulating layer 30 may be in contact with the pixel defining layer PDL. Further, the upper surface 40-U of the fourth insulating layer 40, which is exposed from the fifth insulating layer 50, may be also in contact with the pixel defining layer PDL. According to some embodiments, the fourth insulating layer 40 may be spaced apart from the transmissive area TA1.

According to some embodiments, the upper surface 10-E of the first insulating layer 10 may be exposed from the third insulating layer 30 and the pixel defining layer PDL through the second insulating opening 30-OP and the transmissive opening T-OP.

Referring to FIG. 6C, in a display panel DP-B according to some embodiments, at least some of the insulating layers arranged in the transmissive area TA1 may be removed to relatively improve the transmittance of the transmissive area TA1.

According to some embodiments, the base layer BS may be located in the transmissive area TA1. The fourth insulating layer 40 may include the first insulating opening 40-OP that overlaps the transmissive area TA1. The first insulating opening 40-OP may be defined by the side surface 40-S of the fourth insulating layer 40, which is formed as the portion of the fourth insulating layer 40, which overlaps the transmissive area TA1, is passed therethrough.

The third insulating layer 30 may include the second insulating opening 30-OP that overlaps the transmissive area TA1. The second insulating opening 30-OP may overlap the first insulating opening 40-OP. The second insulating opening 30-OP may be defined by the side surface 30-S of the third insulating layer 30, which is formed as the portion of the third insulating layer 30, which overlaps the transmissive area TA1, is passed therethrough.

According to some embodiments, the first insulating layer 10 may include a third insulating opening 10-OP that overlaps the transmissive area TA1. The third insulating opening 10-OP may overlap the first insulating opening 40-OP and the second insulating opening 30-OP. The third insulating opening 10-OP may be defined by a side surface 10-S of the first insulating layer 10, which is formed as a portion of the third insulating layer 10, which overlaps the transmissive area TA1, is passed therethrough.

In the pixel defining layer PDL, the display opening PDL-OP (see FIG. 5) corresponding to the light emitting areas PXA1-1, PXA1-2, and PXA1-3 described in FIG. 3B and the transmissive opening T-OP corresponding to the transmissive area TA1 described in FIG. 3B may be defined. The transmissive opening T-OP may overlap the first insulating opening 40-OP to the third insulating opening 10-OP. The transmissive opening T-OP may be defined by the side surface PDL-S of the pixel defining layer PDL, which is formed as the portion of the pixel defining layer PDL, which overlaps the transmissive area TA1, is passed therethrough.

According to some embodiments, the side surface 40-S of the fourth insulating layer 40 that defines the first insulating opening 40-OP, the side surface 30-S of the third insulating layer 30 that defines the second insulating opening 30-OP, and the side surface 10-S of the first insulating layer 10 that defines the third insulating opening 10-OP may be covered by the pixel defining layer PDL. That is, the side surface 40-S of the fourth insulating layer 40, the side surface 30-S of the third insulating layer 30, and the side surface 10-S of the first insulating layer 10 may be in contact with the pixel defining layer PDL. Further, the upper surface 40-U of the fourth insulating layer 40, which is exposed from the fifth insulating layer 50, may be also in contact with the pixel defining layer PDL. According to some embodiments, the fourth insulating layer 40 may be spaced apart from the transmissive area TA1.

According to some embodiments, the upper surface BS-E of the base layer BS may be exposed from the first insulating layer 10 and the pixel defining layer PDL through the third insulating opening 10-OP and the transmissive opening T-OP.

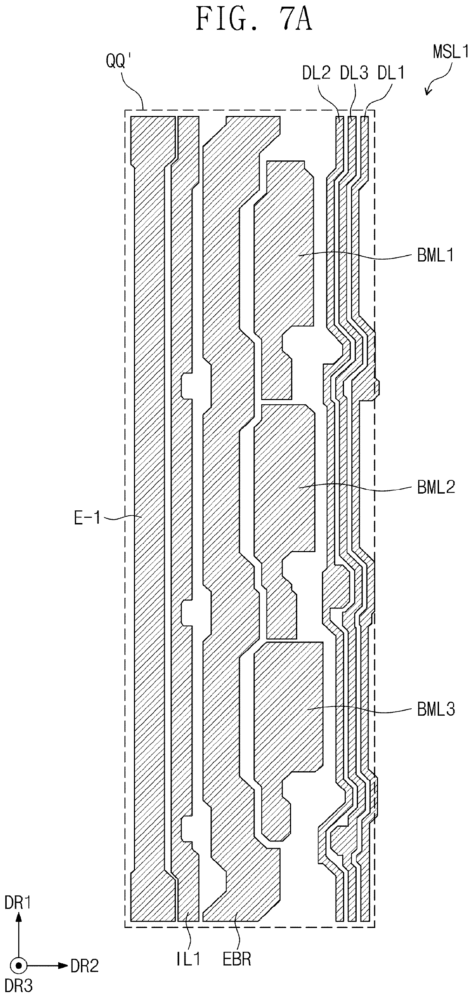

FIGS. 7A to 7H are plan views illustrating a laminated sequence of conductive patterns arranged in area QQ' of FIG. 3B, which is distinguished according to each layer. FIGS. 7A to 7H illustrate conductive patterns arranged in the light emitting areas PXA1-1, PXA1-2, and PXA1-3 and the first wiring area LA1 described in FIG. 3B according to each layer. Hereinafter, the pixel circuits PC (see FIG. 4) included in three pixels arranged in the one unit area PU will be described with reference to FIGS. 7A to 7H. The description will be made with reference to the configurations described in the FIGS. 5 and 6A.

Referring to FIG. 7A, the display panel DP (see FIG. 5) according to some embodiments may include a first conductive layer MSL1. The first conductive layer MSL1 may be located on the base layer BS and covered by the first insulating layer 10.

The first conductive layer MSL1 may include a first line E-1, a first reference line IL1, a first power pattern EBR, first to third light shielding patterns BML1, BML2, and BML3, and first to third data lines DL1, DL2, and DL3. The first conductive layer MSL1 may include sequentially laminated metal layers. A first layer may include titanium, and a second layer may include copper.

Each of the first line E-1, the first reference line IL1, the first power pattern EBR, and the first to third data lines DL1, DL2, and DL3 may extend in the first direction DR1. The first to third light shielding patterns BML1, BML2, and BML3 may be spaced apart from each other in the first direction DR1. The first line E-1 may be spaced apart from the first power line EBR in the second direction DR2 with the first reference line IL1 interposed therebetween. The first power line EBR may be located between the first reference line IL1 and the first to third light shielding patterns BML1, BML2, and BML3.

Among the first to third data lines DL1, DL2, and DL3, the second data line DL2 may be located closest to the first to third light shielding patterns BML1, BML2, and BML3, and the third data line DL3 may be located between the first data line DL1 and the second data line DL2.

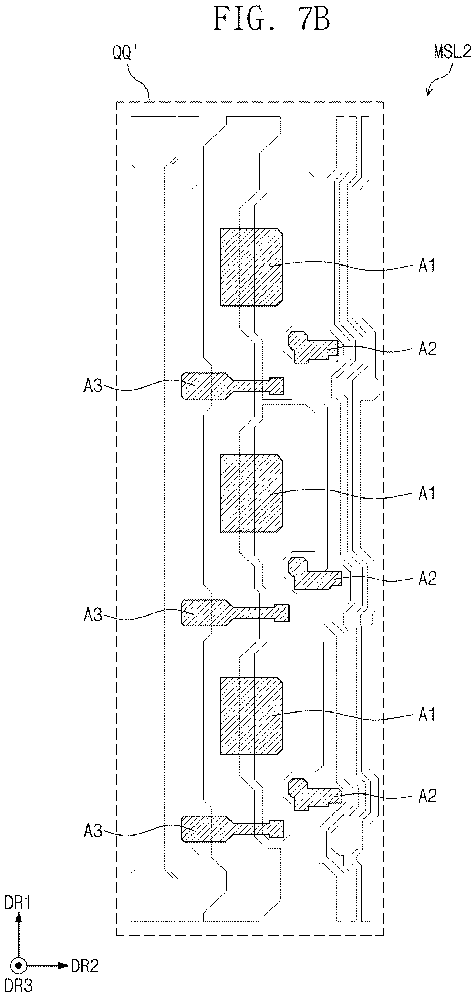

Referring to FIG. 7B, the display panel DP (see FIG. 5) according to some embodiments may include a second conductive layer MSL2. The second conductive layer MSL2 may be located on the first insulating layer 10 and covered by the second and third insulating layers 20 and 30.

The second conductive layer MSL2 may include first to third active patterns A1, A2, and A3 included in the three pixels. A portion of the first active pattern A1 may overlap the first power pattern EBR, and the other portion of the first active pattern A1 may be overlap a corresponding light shielding pattern among the first to third light shielding patterns BML1, BML2, and BML3. The second conductive layer MSL2 may include indium gallium zinc oxide (IGZO).

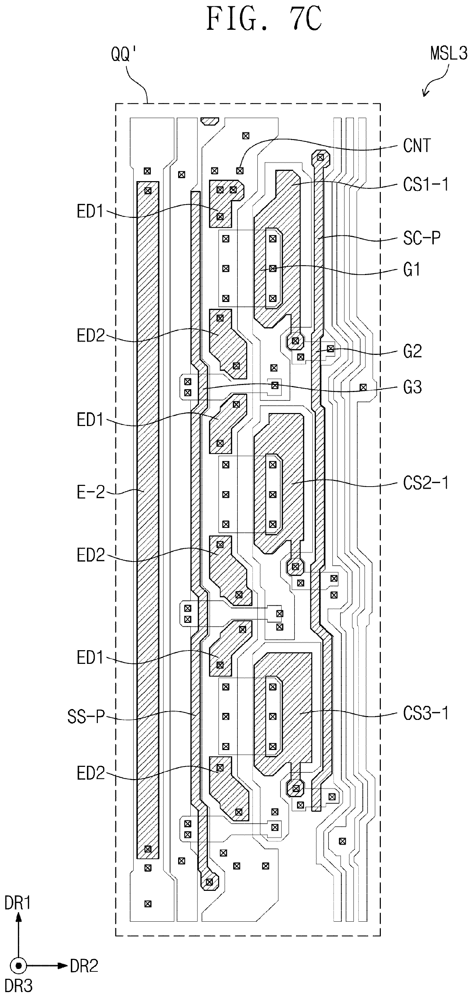

Referring to FIG. 7C, the display panel DP (see FIG. 5) according to some embodiments may include a third conductive layer MSL3. The third conductive layer MSL3 may be located on the first insulating layer 10 and the second insulating layer 20. FIG. 7C together illustrates contact holes CNT passing through at least one of the first to third insulating layers 10, 20, or 30 described in FIG. 5.

Contact holes that overlap the first conductive layer MSL1 and the second conductive layer MSL2 among the contact holes CNT may be defined by penetrating the first insulating layer 10, contact holes that overlap the second conductive layer MSL2 and the third conductive layer MSL3 among the contact holes CNT may be defined by penetrating the second insulating layer 20, contact holes that overlap the third conductive layer MSL3 and a fourth conductive layer MSL4 among the contact holes CNT may be defined by penetrating the third insulating layer 30, and contact holes that overlap the first conductive layer MSL1 and the fourth conductive layer MSL4 among the contact holes CNT may be defined by penetrating the first insulating layer 10 and the third insulating layer 30.

The third conductive layer MSL3 may include the first line E-1, a sensing pattern SS-P, power patterns ED1 and ED2, first to third lower capacitor patterns CS1-1, CS2-1, and CS3-1, and a scan pattern SC-P. The third conductive layer MSL3 may include sequentially laminated metal layers. A first layer may include titanium, and a second layer may include copper.

An area of the first active pattern A1, which overlaps the first to third lower capacitor patterns CS1-1, CS2-1, and CS3-1, may be defined as the gate G1 of the first transistor T1 (see FIG. 4), an area of the second active pattern A2, which overlaps the scan pattern SC-P, may be defined as the gate G2 of the second transistor T2 (see FIG. 4), and an area of the third active pattern A3, which overlaps the sensing pattern SS-P, may be defined as the gate G3 of the third transistor T3 (see FIG. 4).

Portions of the first to third lower capacitor patterns CS1-1, CS2-1, and CS3-1, which do not overlap the first active pattern A1, may overlap first to third upper capacitor patterns CS1-2, CS2-2, and CS3-2, which will be described below, in one-to-one correspondence, and thus may form the capacitor Cst described in FIG. 4. The first to third lower capacitor patterns CS1-1, CS2-1, and CS3-1 may be connected to the corresponding second active pattern A2 through the contact hole CNT.

A second line E-2 may extend in the first direction DR1 and overlap the first line E-1. The second line E-2 may be connected to the first line E-1 through second contact holes CNT2.

The sensing pattern SS-P may extend in the first direction DR1 and be located between the first reference line IL1 and the first power pattern EBR on a plane.

The scan pattern SC-P may extend in the first direction DR1 and may be located between the first to third lower capacitor patterns CS1-1, CS2-1, and CS3-1 and the first to third data lines DL1, DL2, and DL3 on a plane.

The first and second power patterns ED1 and ED2 may overlap the first power pattern EBR on a plane. The first and second power patterns ED1 and ED2 may be spaced apart from each other in the first direction DR1. The first and second power patterns ED1 and ED2 may be arranged in each pixel. Thus, six power patterns may be arranged in the one unit area PU. The first and second power patterns ED1 and ED2 may be connected to the first power pattern EBR through the contact hole CNT.

Referring to FIG. 7D, the display panel DP (see FIG. 5) according to some embodiments may include the fourth conductive layer MSL4. The fourth conductive layer MSL4 may be located on the third insulating layer 30 and covered by the fourth insulating layer 40.

The fourth conductive layer MSL4 may include a third line E-3, a second reference line IL2, a second power pattern EB-P, the first to third upper capacitor patterns CS1-2, CS2-2, and CS3-2, first to third connection patterns A-P1, A-P2, and A-P3, and first to third data patterns DL-P1, DL-P2, and DL-P3. The fourth conductive layer MSL4 may include sequentially laminated metal layers. A first layer may include titanium, a second layer may include copper, and a third layer may include indium tin oxide (ITO).

The third line E-3 may overlap the second line E-2 and extend in the first direction DR1. The third line E-3 may be connected to the first line E-1 and the second line E-2 through the contact holes CNT. The first line E-1 to the third line E-3 may be provided in multiple layers and connected to each other, thereby reducing resistance. The description related thereto may be commonly applied to conductive patterns provided in multiple layers and connected to each other.

The second reference line IL2 may overlap the first reference line IL1 and extend in the first direction DR1. The second reference line IL2 may be connected to the first reference line IL1 through the contact holes CNT.

The second power pattern EB-P may overlap the first power pattern EBR and the first and second power patterns ED1 and ED2 and extend in the first direction DR1. The second power pattern EB-P may be connected to the first power pattern EBR and the first and second power patterns ED1 and ED2 through the contact holes CNT. Further, the second power pattern EB-P may be connected to one side of the first active pattern A1 through the contact holes CNT.

The first to third upper capacitor patterns CS1-2, CS2-2, and CS3-2 may respectively overlap the first to third lower capacitor patterns CS1-1, CS2-1, and CS3-1 and may be connected through the contact holes CNT. Further, each of the first to third upper capacitor patterns CS1-2, CS2-2, and CS3-2 may be connected to the other side of the first active pattern A1 through corresponding contact holes CNT.

The first connection pattern A-P1 may connect the second active pattern A2 and the first lower capacitor pattern CS1-1 through the contact holes CNT. The second connection pattern A-P2 may connect the second active pattern A2 and the second lower capacitor pattern CS2-1 through the contact holes CNT. The third connection pattern A-P3 may connect the third active pattern A3 and the third lower capacitor pattern CS3-1 through the contact holes CNT.

The first data pattern DL-P1 may connect the second active pattern A2 and the first data line DL1 through contact holes CNT. The second data pattern DL-P2 may connect the second active pattern A2 and the second data line DL2 through contact holes CNT. The third data pattern DL-P3 may connect the second active pattern A2 and the third data line DL3 through contact holes CNT.

The first wiring area LA1 and the second wiring area LA2 described in FIG. 3B may include the sensing line SSL, the power line EDL, and the scan line SCL that extend in the second direction DR2 and are spaced apart from each other in the first direction DR1.

The sensing line SSL may be connected to the sensing pattern SS-P through the contact hole CNT. The scan line SCL may be connected to the scan pattern SC-P through the contact hole CNT. The power line EDL may be connected to the first power pattern EBR through the contact hole CNT.

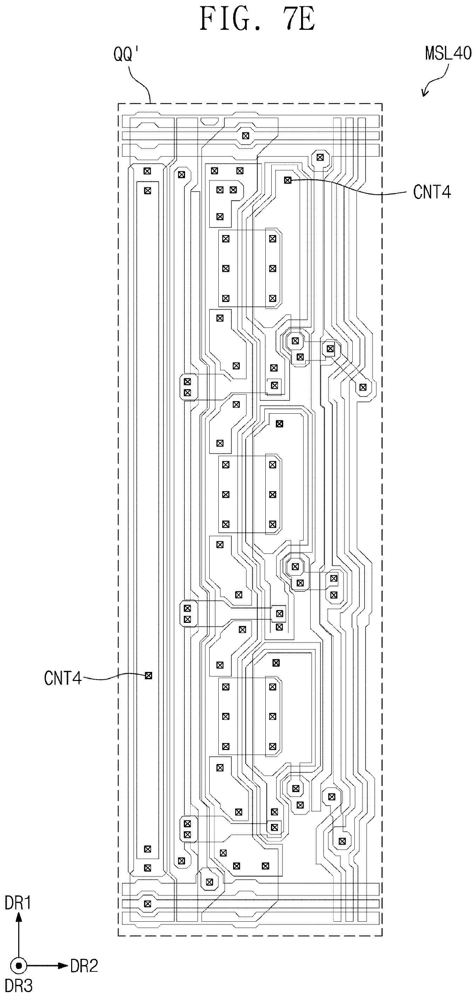

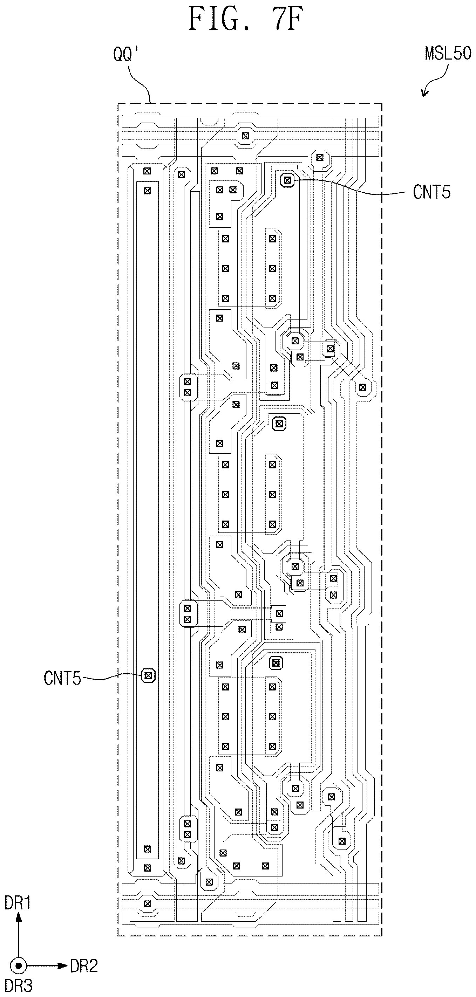

FIG. 7E illustrates fourth contact holes CNT4 passing through the fourth insulating layer 40 described in FIG. 5, and FIG. 7F illustrates fifth contact holes CNT5 passing through the fifth insulating layer 50 described in FIG. 5. The fourth insulating layer 40 may include silicon nitride, and the fifth insulating layer 50 may include PSPI.

The fourth contact holes CNT4 may be defined in the fourth insulating layer 40 that overlaps the first to third upper capacitor patterns CS1-2, CS2-2, and CS3-2. Further, at least one fourth contact hole CNT4 may be defined in the fourth insulating layer 40 that overlaps the third line E-3.

The fifth contact holes CNT5 may be defined in the fifth insulating layer 50 that overlaps the fourth contact holes CNT4.

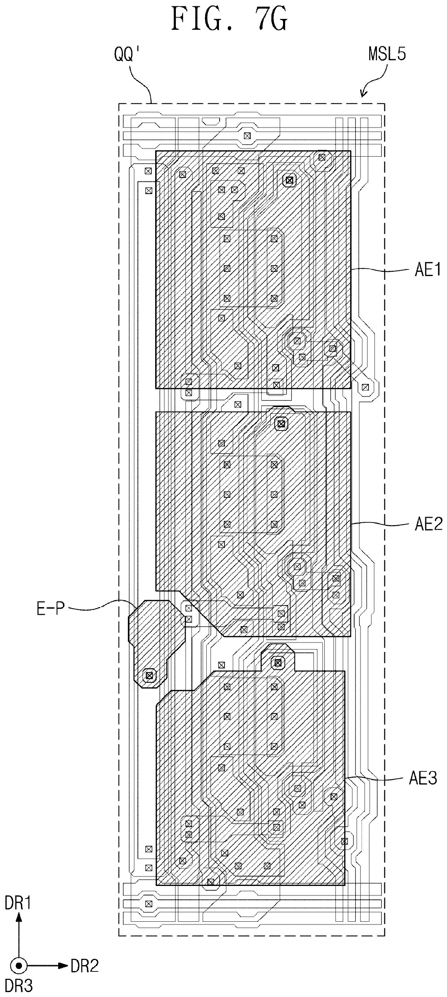

Referring to FIG. 7G, a fifth conductive layer MSL5 may include first electrodes AE1, AE2, and AE3 included in the light emitting elements OLED described in FIG. 5. Further, the fifth conductive layer MSL5 may include a power pattern E-P that overlaps the third line E-3. The fifth conductive layer MSL5 may include sequentially laminated metal layers. A first layer may include indium tin oxide (ITO), a second layer may include silver, and a third layer may include indium tin oxide (ITO).

The first electrodes AE1, AE2, and AE3 may be spaced apart from each other in the first direction DR1. The first electrodes AE1, AE2, and AE3 may be connected to the first to third upper capacitor patterns CS1-2, CS2-2, and CS3-2 through the fourth contact holes CNT4 and the fifth contact holes CNT5. The first electrodes AE1, AE2, and AE3 may receive the first voltage ELVDD through the power line EDL.

The power pattern E-P may be connected to the third line E-3 through the fourth contact hole CNT4 and the fifth contact hole CNT5. The second electrode CE described in FIG. 5 may be connected to the power pattern E-P. The second electrode CE may receive the second voltage ELVSS. The light emitting element OLED may emit a light beam by receiving the first voltage ELVDD and the second voltage ELVSS.

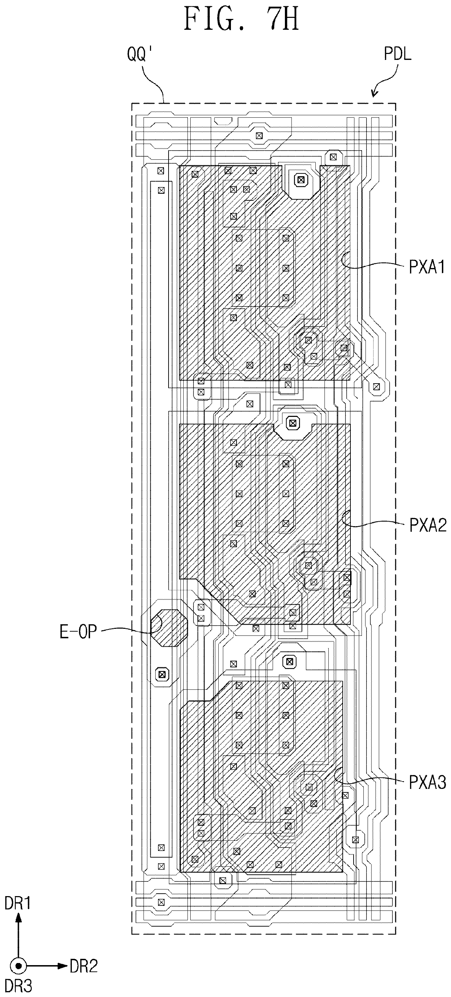

Referring to FIG. 7H, the pixel defining layer PDL may include first to third display openings PXA1, PXA2, and PXA3 through which at least portions of the first electrodes AE1, AE2, and AE3 are exposed. The first to third display openings PXA1, PXA2, and PXA3 may correspond to the first to third light emitting areas PXA1-1, PXA1-2, and PXA1-3 described in FIG. 3B in one-to-one correspondence. The pixel defining layer PDL may include PSPI.

The pixel defining layer PDL may include a power opening E-OP through which at least a portion of the power pattern E-P is exposed. The second electrode CE described in FIG. 5 may be connected to the power pattern E-P through the power opening E-OP.

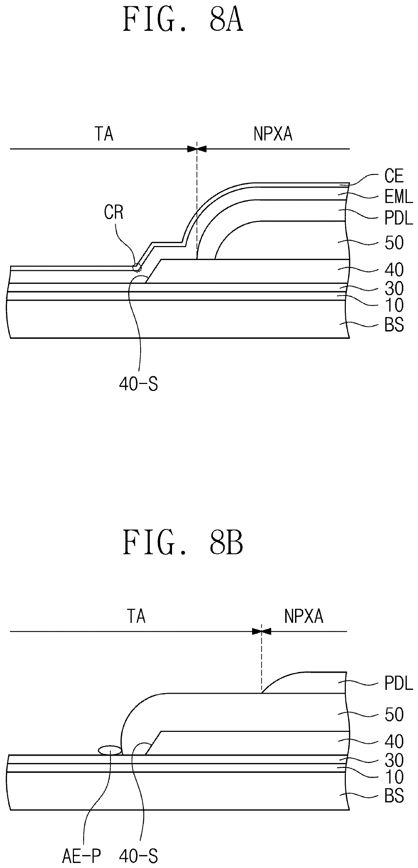

FIGS. 8A to 8C are cross-sectional views according to comparative examples. FIGS. 8A to 8C are comparative examples for describing a problem that may occur when the side surface 40-S of the fourth insulating layer 40 including silicon nitride is not covered by the pixel defining layer PDL, unlike the present invention.

As illustrated in FIG. 8A, according to a first comparative example, the side surface 40-S of the fourth insulating layer 40 including silicon nitride may be exposed from the pixel defining layer PDL. In this case, cracks CR may occur in the second electrode CE entirely formed on the base layer BS due to a step of the light emitting layer EML formed by the side surface 40-S of the fourth insulating layer 40. Accordingly, the second electrode CE may be disconnected. This may reduce the reliability of the transparent display panel.

As illustrated in FIG. 8B, according to a second comparative example, unlike the present invention, the fifth insulating layer 50 including an organic material may cover the side surface 40-S of the fourth insulating layer 40. When the fifth insulating layer 50 having a relatively large thickness covers the side surface 40-S of the fourth insulating layer 40, when the first electrode AE (see FIG. 5) is removed from the transmissive area TA by an etching process in a subsequent process, a problem may occur in which particles AE-P remain at an end portion of the fifth insulating layer 50. This may reduce the transparency of the transmissive area in the transparent display panel.

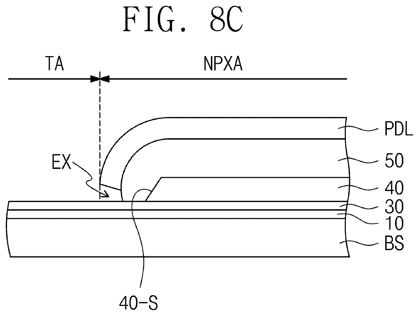

As illustrated in FIG. 8C, according to a third comparative example, the pixel defining layer PDL may cover the fifth insulating layer 50 that covers the side surface 40-S of the fourth insulating layer 40. In this case, a contact area between the pixel defining layer PDL and the third insulating layer 30 including an inorganic material is reduced, and thus a distal end of the pixel defining layer PDL may be peeled off from the third insulating layer 30.

As described in FIG. 6A, according to the display panel DP according to the present invention, the upper surface 40-U and the side surface 40-S of the fourth insulating layer 40 including silicon nitride may be exposed from the fifth insulating layer 50 and covered by the pixel defining layer PDL. Further, the pixel defining layer PDL covers the fourth insulating layer 40 including an inorganic material and is in contact with the third insulating layer 30, and thus a contact area between the pixel defining layer PDL and the third insulating layer 30 may be secured. Accordingly, the display panel DP having increased transparency in the transmissive area TA and relatively improved reliability may be provided.

According to some embodiments of the present invention, a display panel having relatively increased transparency and relatively improved reliability in a transmissive area included in a display area of the display panel may be provided.

Although the description has been made above with reference to aspects of some embodiments of the present invention, it may be understood that those skilled in the art or those having ordinary knowledge in the art may variously modify and changes the present disclosure without departing from the technical scope of the present invention described in the appended claims.

Thus, the technical scope of embodiments according to the present invention are not limited to the detailed description of the specification, but should be defined by the appended claims.

## Claims

1. A display panel (DP) comprising:
a base layer (BS) including a display area (DA) including a transmissive area (TA1, TA2) and a non-display area (NDA) adjacent to the display area (DA);
a light shielding pattern (BML) on the base layer (BS);
a first insulating layer (10) covering the light shielding pattern (BML);
a transistor (T1) overlapping the light shielding pattern (BML) and including a semiconductor pattern on the first insulating layer (10) and a gate (G1) on the semiconductor pattern;
a second insulating layer (20) between the semiconductor pattern and the gate (G1);
a third insulating layer (30) covering the transistor (T1);
a first connection electrode (CNE1) on the third insulating layer (30) and connected to the semiconductor pattern through a contact hole defined in the third insulating layer (30);
a fourth insulating layer (40) covering the first connection electrode (CNE1);
a pixel defining layer (PDL) including a display opening (PDL-OP) not overlapping the transmissive area (TA1, TA2) and on the fourth insulating layer (40); and
a light emitting element (OLED) on the fourth insulating layer (40) and including a first electrode (AE) exposed by the display opening (PDL-OP) and connected to the first connection electrode (CNE1) and a second electrode (CE), and a light emitting layer (EML) between the first electrode (AE) and the second electrode (CE),
wherein the fourth insulating layer (40) includes a first insulating opening (40-OP) overlapping the transmissive area (TA1, TA2), and
the pixel defining layer (PDL) includes a transmissive opening (T-OP) overlapping the first insulating opening (40-OP).

2. The display panel (DP) of claim 1, wherein a width of the first insulating opening (40-OP) is greater than a width of the transmissive opening (T-OP) on a plane.

3. The display panel (DP) of claim 1 or 2, wherein a side surface (40-S) of the fourth insulating layer (40), which defines the first insulating opening (40-OP), contacts the pixel defining layer (PDL).

4. The display panel (DP) of at least one of claims 1 to 3, wherein the fourth insulating layer (40) includes silicon nitride, and
the pixel defining layer (PDL) includes photosensitive polyimide, PSPI.

5. The display panel (DP) of at least one of claims 1 to 4, wherein, in the transmissive area (TA1, TA2), the third insulating layer (30) is exposed from the pixel defining layer (PDL) through the transmissive opening (T-OP).

6. The display panel (DP) of at least one of claims 1 to 5, wherein the third insulating layer (30) includes a second insulating opening (30-OP) overlapping the first insulating opening (40-OP), and
a side surface (40-S) of the fourth insulating layer (40), which defines the first insulating opening (40-OP), and a side surface (30-S) of the third insulating layer (30), which defines the second insulating opening (30-OP), are in contact with the pixel defining layer (PDL).

7. The display panel (DP) of claim 6, wherein, in the transmissive area (TA1, TA2), the first insulating layer (10) is exposed from the pixel defining layer (PDL) through the transmissive opening (T-OP).

8. The display panel (DP) of claim 6, wherein the first insulating layer (10) includes a third insulating opening (10-OP) overlapping the second insulating opening (30-OP), and
a side surface (10-S) of the first insulating layer (10), which defines the third insulating opening (10-OP), is in contact with the pixel defining layer (PDL).

9. The display panel (DP) of claim 8, wherein, in the transmissive area (TA1, TA2), the base layer (BS) is exposed from the pixel defining layer (PDL) through the transmissive opening (T-OP).

10. The display panel (DP) of at least one of claims 1 to 9, further comprising:
a data line (DL) connected to the transistor (T1),
wherein the data line (DL) is on a same layer as the light shielding pattern (BML).

11. The display panel (DP) of at least one of claims 1 to 10, wherein an area of the display opening (PDL-OP) is smaller than an area of the transmissive opening (T-OP).

12. The display panel (DP) of at least one of claims 1 to 11, further comprising:
a fifth insulating layer (50) between the fourth insulating layer (40) and the pixel defining layer (PDL),
wherein the fifth insulating layer (50) includes an upper insulating opening overlapping the first insulating opening (40-OP), and
a side surface of the fifth insulating layer (50), which defines the upper insulating opening, is in contact with the pixel defining layer (PDL).

13. The display panel (DP) of claim 12, wherein an upper surface (40-U) of the fourth insulating layer (40), which is adjacent to a side surface (40-S) of the fourth insulating layer (40), which defines the first insulating opening (40-OP), is exposed from the fifth insulating layer (50) through the upper insulating opening, and
the upper surface (40-U) is in contact with the pixel defining layer (PDL).

14. The display panel (DP) of claim 12 or 13, wherein the fifth insulating layer (50) includes photosensitive polyimide, PSPI.

15. The display panel (DP) of at least one of claims 12 to 14, further comprising:
a second connection electrode (CNE2) on the fourth insulating layer (40), covered by the fifth insulating layer (50), and connected to the first connection electrode (CNE1) through a contact hole defined in the fourth insulating layer (40).

16. The display panel (DP) of at least one of claims 1 to 15, wherein the first insulating layer (10) includes a first layer including silicon nitride and a second layer including silicon oxide,
the second insulating layer (20) includes silicon oxide, and
the third insulating layer (30) includes silicon oxy nitride.

17. The display panel (DP) of at least one of claims 1 to 16, wherein each of the light shielding pattern (BML) and the gate (G1) includes a first layer including titanium and a second layer including copper,
the semiconductor pattern includes indium gallium zinc oxide, IGZO, and
the first connection electrode (CNE1) includes a first layer including titanium, a second layer including copper, and a third layer including indium tin oxide, ITO.

18. The display panel (DP) of at least one of claims 1 to 17, wherein the first electrode (AE) includes a first layer including indium tin oxide, ITO, a second layer including silver, and a third layer including ITO.

19. The display panel (DP) of at least one of claims 1 to 18, further comprising:
an encapsulation layer (TFE) covering the light emitting element (OLED) and including inorganic layers and an organic layer between the inorganic layers.

20. The display panel (DP) of at least one of claims 1 to 19, wherein a virtual object (PD) on a rear surface (D-P) of the display panel (DP) is transparent and visible from a front surface (D-U) of the display panel (DP).
